# EUROPÄISCHE PATENTANMELDUNG

(11) **EP 0 741 506 A2**
(43) Veröffentlichungstag der Anmeldung: **06.11.1996**
(21) Anmeldenummer: 96106299.9
(22) Anmeldetag: 22.04.1996
(51) Int. Cl.: H05K 7/14, H05K 5/00, H02B 1/34

(54) **Baugruppenträger sowie Schrank mit einem derartigen Baugruppenträger**

(30) Priorität: 02.05.1995 DE 29507255 U
(71) Anmelder: SIEMENS AKTIENGESELLSCHAFT, 80333 München (DE)
(72) Erfinder: Roster, Thomas, 76275 Ettlingen (DE); Schmitt, Reinhard, 76829 Landau (DE)

(57) **Zusammenfassung**

Die Erfindung betrifft einen Baugruppenträger zum Einbau in ein Gestell oder einen Schrank des 19''-Aufbausystems, der sowohl Einbauplätze für Baugruppen (4) aufweist, die von vorne bestückbar sind, als auch Einbauplätze, die von hinten bestückbar sind. Eine Übergabeleiterplatte (14) in einem Schrank mit einem derartigen Baugruppenträger weist sowohl im vorderen als auch im hinteren Bereich Anschlußelemente (19) zur Übergabe der Versorgungsspannungen an die von vorne bzw. die von hinten bestückbaren Baugruppen (4) auf. Durch die Erfindung wird die Raumnutzung in Schränken der Automatisierungstechnik verbessert.

Die Erfindung wird angewandt in Elektronikschränken.

## Beschreibung

Die Erfindung betrifft einen Baugruppenträger nach dem Oberbegriff des Anspruchs 1 sowie einen Schrank, insbesondere eines Automatisierungssystems, mit einem Gestell zur Aufnahme eines derartigen Baugruppenträgers nach dem Oberbegriff des Anspruchs 5.

Derartige Einrichtungen sind aus dem DE-GM 93 11 526 bekannt. Dort ist ein Schrankgestell eines Automatisierungssystems beschrieben, welches aus Längs- und Querholmen besteht. In das Gestell sind Baugruppenträger eingebaut, die mit Baugruppen, z. B. digitalen Ein- und Ausgabebaugruppen, bestückt sind. Stromschienen verlaufen vertikal am rechten Längsholm und sind an einer Leiterplatte angeschlossen, die vertikal im unteren Bereich des Längsträgers angeordnet und mit Einspeisedioden zur Trennung der Versorgungsspannungen bei redundanter Einspeisung versehen ist. Den Baugruppenträgern sind Übergabeleiterplatten zugeordnet, die mit Anschlußelementen zur Übergabe der Versorgungsspannungen an die Baugruppen in den Baugruppenträgern versehen sind und Sicherungsautomaten tragen.

Die Funktionsdichte der Komponenten in Automatisierungssystemen wird aufgrund der Verkleinerung ihrer Abmessungen immer höher. Dies trifft insbesondere bei der prozeßnahen Peripherie, den Ein- und Ausgabebaugruppen, zu. Dagegen verringert sich die Anzahl der Aktoren und Sensoren in Anlagen, die mit Automatisierungssystemen gesteuert werden sollen, nur unwesentlich. Auch der Platzbedarf für die Prozeßanschlußtechnik der Ein-/Ausgabebaugruppen, die zum Anschluß der Aktoren und Sensoren an die Baugruppen des Baugruppenträgers dient, bleibt konstant. Diese ist üblicherweise auf der Frontseite der Flachbaugruppen angeordnet und bestimmt somit wesentlich die Anzahl der in einem Automatisierungssystem für eine spezielle Automatisierungsaufgabe erforderlichen Ein- und Ausgabebaugruppen.

Der Erfindung liegt die Aufgabe zugrunde, einen Baugruppenträger zu schaffen, der bei geringem Aufwand eine bessere Raumnutzung, insbesondere in einem Automatisierungssystem, gewährleistet, sowie einen Schrank zur Aufnahme eines derartigen Baugruppenträgers anzupassen.

Zur Lösung dieser Aufgabe weist der neue Baugruppenträger der eingangs genannten Art das im kennzeichnenden Teil des Anspruchs 1 genannte Merkmal bzw. der neue Schrank zur Aufnahme eines derartigen Baugruppenträgers das im kennzeichnenden Teil des Anspruchs 5 genannte Merkmal auf. In den weiteren Unteransprüchen sind vorteilhafte Weiterbildungen der Erfindung beschrieben.

Die Erfindung hat den Vorteil, daß der neue Baugruppenträger sowohl auf der Vorder- als auch auf der Rückseite eine zur Unterbringung der Prozeßanschlußtechnik geeignete Frontfläche bietet. Es können somit bei gleichem Volumen mehr externe Leitungen an Ein- und Ausgabebaugruppen des Baugruppenträgers angeschlossen werden. Gemäß Anspruch 2 können in vorteilhafter Weise etwa gleich große oder auch dieselben Baugruppen von vorne und von hinten in einen Baugruppenträger eingebaut werden. Durch die Merkmale des Anspruchs 3 wird eine Mischbestückung in einem 19''-Aufbausystem ermöglicht, d. h. eine gleichzeitige Bestückung mit Baugruppenträgern, die speziell für das 19''-Aufbausystem vorgesehen sind, und mit Baugruppen, die keiner Norm entsprechen und auf eine sogenannte Hutschiene aufgeschnappt werden. Die Erfindung ermöglicht es, eine Vielzahl von Ein- und Ausgabebaugruppen mit kleinen Abmessungen in ein 19''-Aufbausystem wirtschaftlich zu integrieren, wobei gemeinsame Komponenten, beispielsweise die Stromversorgungseinspeisung, Stromversorgungsverteilung, Stromversorgungsabsicherung, Entwärmung, Leittechniküberwachung, Rangierung externer Leitungen und die zugehörige Prozeßanschlußtechnik, gemeinsam in einer einheitlichen Aufbautechnik genutzt werden. Dabei ist keine aufwendige Lösung mit einem Schwenkrahmen zum Herausschwenken des 19''-Aufbausystems aus einem Schrank erforderlich, und es muß nicht aus Gründen der Kompatibilität zu anderen Schränken der Anlage auf die Nutzung des vorhandenen Schrankvolumens verzichtet werden.

Anhand der Zeichnungen, in denen Ausführungsbeispiele der Erfindung dargestellt sind, werden im folgenden die Erfindung sowie Ausgestaltungen und Vorteile näher erläutert.

Es zeigen:
- Figur 1: eine Perspektivansicht eines erfindungsgemäßen Baugruppenträgers und
- Figur 2: einen in ein 19''-Aufbausystem eingebauten Baugruppenträger mit Übergabeleiterplatte.

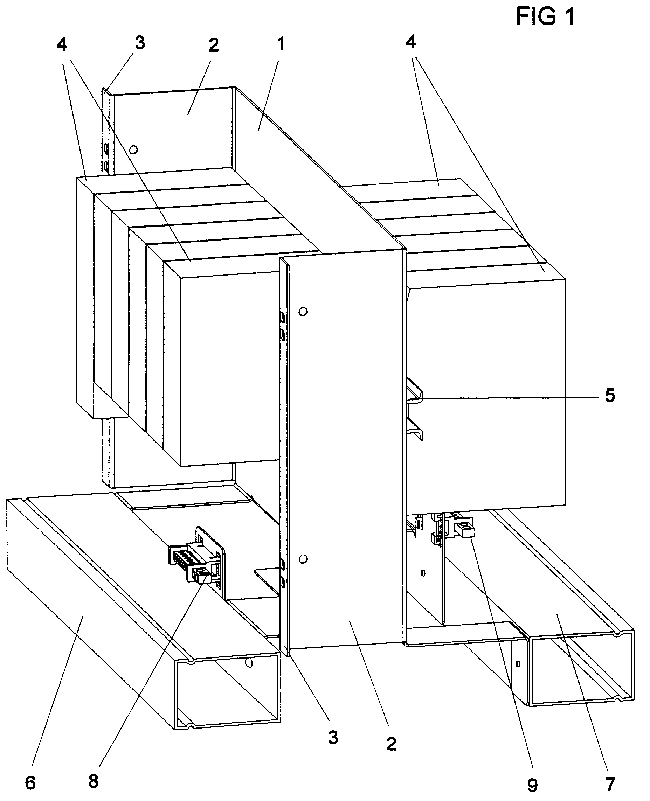

Ein erfindungsgemäßer Baugruppenträger besteht gemäß Figur 1 im wesentlichen aus einem flachen, U-förmigen Blech 1, das senkrecht im Gestell eines 19''-Aufbausystems einbaubar ist. Dazu ist das U-förmige Blech 1 an den Enden seiner Schenkel 2 mit rechtwinklig nach außen abgebogenen, gelochten Laschen 3 versehen, deren Abmessungen so gewählt sind, daß sie an den senkrechten Befestigungsschienen des 19''-Aufbausystems anschraubbar sind. Die Länge der Schenkel 2 bestimmt die Lage der Einbauplätze für Flachbaugruppen 4, die in diesem Ausführungsbeispiel bis etwa zur halben Tiefe des Baugruppenträgers reichen. Die Einbauplätze des Baugruppenträgers sind somit sowohl von vorne als auch von hinten mit gleichen Baugruppen bestückbar. Das Joch des U-förmigen Blechs 1 bildet eine Befestigungsebene für die Baugruppen 4 und ist an seiner Vorder- und Rückseite jeweils mit einer querverlaufenden Hutschiene versehen, an welcher die Baugruppen 4 befestigt sind. In Figur 1 ist nur die rückseitige Hutschiene 5 sichtbar. Es ist in Figur 1 deutlich zu erkennen, daß sowohl an der Vorderseite als auch an der Rückseite des Baugruppenträgers, wenn Ein- oder Ausgabebaugruppen als Baugruppen 4 eingesetzt sind, Anschlußstellen für externe Leitungen vorgesehen werden können und somit eine verbesserte Raumnutzung in einem 19''-Aufbausystem ermöglicht wird. Zur leichten Verlegung und Zuführung der externen Leitungen, die in Figur 1 der Übersichtlichkeit wegen nicht dargestellt sind, dienen Kabelkanäle 6 und 7, die jeweils an der Vorderseite und der Rückseite des Baugruppenträgers an geeignet gebogenen Laschen des Blechs 1 als Haltevorrichtung befestigt sind. Potentialvervielfacher 8 und 9 sind in dafür geeignete Durchbrechungen des Blechteils 1 eingeschnappt und befinden sich direkt über den Kabelkanälen 6 bzw. 7. Diese Anordnung ermöglicht ein einfaches Anklemmen und sicheres Verlegen der für die Baugruppen 4 erforderlichen Versorgungsleitungen.

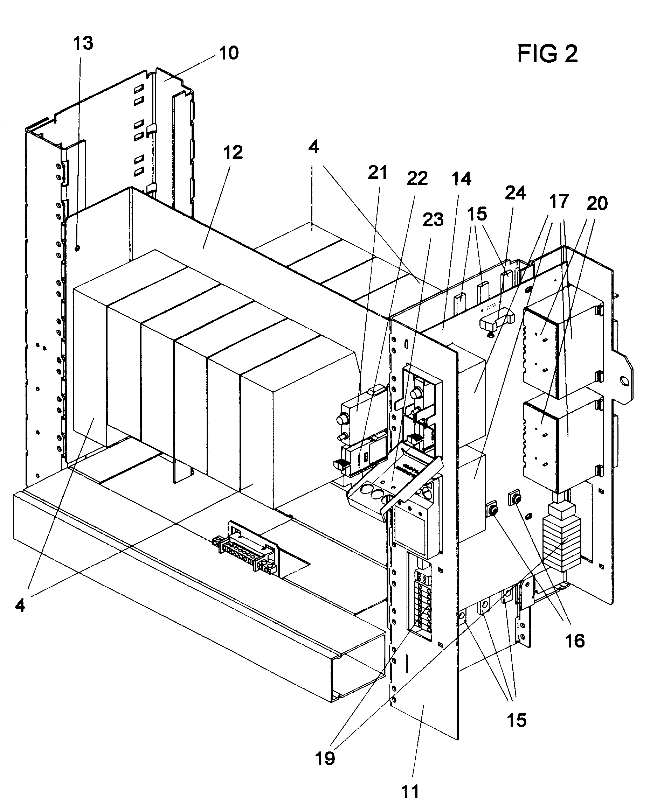

Figur 2 zeigt eine zweite Version eines erfindungsgemäßen Baugruppenträgers, der zwischen zwei Längsholmen 10 und 11 eines 19''-Aufbausystems eingebaut ist. In dieser Version fehlen die in Figur 1 gezeigten Laschen 3 zur Befestigung des Blechs an den Lochreihen der Holme 10 und 11; zur Befestigung des Blechs 12 sind vielmehr vier Befestigungsbohrungen paarweise in seinen Schenkeln angebracht, von denen in Figur 2 nur die Bohrung 13 sichtbar ist. Durch diese und dazu korrespondierende Bohrungen in den Längsholmen 10 und 11 können geeignete Schrauben eingesetzt und das Blech 12 mit den Holmen 10 und 11 verschraubt werden. Mit einer Übergabeleiterplatte 14 werden die für die Baugruppen 4 des Baugruppenträgers erforderlichen Versorgungs- und Überwachungspotentiale beidseitig in einem Schrank, dessen Längsholme 10 und 11 in Figur 2 eingezeichnet sind, zur Verfügung gestellt. Die Versorgungspotentiale werden mit Stromschienen 15, die im Längsholm 11 vertikal verlaufen, der Übergabeleiterplatte 14 zugeführt. Die Stromschienen 15 sind niederohmig mit der Übergabeleiterplatte 14 durch Anschlußelemente 16 elektrisch verbunden. Die Anschlußelemente 16 sind so ausgelegt, daß die Niederohmigkeit für die gesamte Produktlebensdauer sicher gewährleistet ist. Bezüglich weiterer Angaben zur Verteilung der Versorgungspotentiale wird auf das bereits erwähnte DE-GM 93 11 526 verwiesen. Die Übergabeleiterplatte 14 ist sowohl an ihrer Vorderkante als auch an ihrer Hinterkante mit Gehäusen 17 für Sicherungsautomaten 21 und Anschlußklemmen 19 versehen. An der Rückseite der Gehäuse 17 befindet sich jeweils eine Leiterplatte 20, die in die Leiterplatte der Übergabeleiterplatte 14 ohne Verwendung einer Steckverbindung durch Schwallen eingelötet ist. Auf diesen Leiterplatten 20 befinden sich Kontaktelemente zur Kontaktierung der Sicherungsautomaten 21 und Überspannungsschutzdioden 22, die in die Gehäuse 17 einsteckbar sind. Mit einer Abdeckung 23, die an den Gehäusen 17 drehbar gelagert ist, werden diese verschlossen und Sicherungsautomaten 21 sowie Überspannungsschutzdioden 22 abgedeckt. Bei geschlossener Abdeckung 23 können die Sicherungsautomaten 21 durch Öffnungen ein- oder ausgeschaltet werden, deren Durchmesser so gewählt ist, daß die Sicherungsautomaten 21 nur mit Hilfe eines Werkzeuges und nicht von Hand ausgeschaltet werden können. Potentiale der Hilfskontakte der Sicherungsautomaten sind zentral mit einem Stecker 24 verbunden. Sind mehrere derartige Übergabeleiterplatten 14 in einem Schrank vorhanden, so können die Stecker 24 mit Hilfe eines Flachbandkabels zu einer Meldeschleife zusammengeschlossen und so die Signale der Hilfskontakte einer übergeordneten Auswertelogik zugeführt werden. In Figur 2 nicht gezeigte Leitungen zur Versorgung der Baugruppen 4 des Baugruppenträgers mit den erforderlichen Betriebsspannungen können jeweils auf beiden Seiten der Übergabeleiterplatte 14 an Anschlußklemmen 19 angelegt werden.

## Patentansprüche

1. Baugruppenträger zum Einbau in ein Gestell oder einen Schrank eines 19''-Aufbausystems, **dadurch gekennzeichnet**, daß er sowohl Einbauplätze für Baugruppen (4) aufweist, die von vorne bestückbar sind, als auch Einbauplätze, die von hinten bestückbar sind.

2. Baugruppenträger nach Anspruch 1, **dadurch gekennzeichnet**, daß die von vorne und die von hinten bestückbaren Einbauplätze jeweils etwa bis zur halben Tiefe des Baugruppenträgers reichen.

3. Baugruppenträger nach Anspruch 1 oder 2, **dadurch gekennzeichnet**, daß er im wesentlichen aus einem U-förmigen Blech (1) besteht, das senkrecht im Gestell des 19''-Aufbausystems einbaubar und mit nach außen rechtwinklig abgebogenen, gelochten Laschen (3) an den Enden der beiden Schenkel (2) des U-förmigen Blechs (1) an Befestigungsschienen (10, 11) des Gestells befestigbar ist, so daß das Joch des U-förmigen Blechs (1) eine Befestigungsebene in der halben Tiefe des Baugruppenträgers bildet, an dessen Vorder- und Rückseite jeweils eine guerverlaufende Hutschiene (5) zur Aufnahme der Baugruppen (4) befestigt ist.

4. Baugruppenträger nach einem der vorhergehenden Ansprüche, **dadurch gekennzeichnet**, daß an Vorder- und/oder Rückseite jeweils ein Kabelkanal (6, 7) zur Zuführung externer Leitungen zu Anschlußstellen der Baugruppen (4) vorhanden ist.

5. Schrank, insbesondere eines Automatisierungssystems, mit einem Gestell zur Aufnahme eines Baugruppenträgers nach einem der vorhergehenden Ansprüche, das Längsholme (10, 11) aufweist, mit an einem Längsholm (11) vertikal verlaufenden Stromschienen (15) und einer mit diesen verbundenen Übergabeleiterplatte (14) zur Verteilung der Versorgungsspannungen zu den Baugruppenträgern, **dadurch gekennzeichnet**, daß die Übergabeleiterplatte (14) sowohl im Bereich ihrer vorderen als auch ihrer hinteren Kante mit Anschlußelementen (19) zur Übergabe der Versorgungsspannungen an die von vorne bzw. die von hinten bestückbaren Baugruppen (4) versehen ist.

6. Schrank nach Anspruch 5, **dadurch gekennzeichnet**, daß die Übergabeleiterplatte (14) sowohl vorne als auch hinten mit Sicherungsautomaten (21) und Überspannungsschutzdioden (22) bestückbar ist.
